# EUROPEAN PATENT APPLICATION

(11) **EP 3 282 472 A1**
(43) Date of publication of application: **14.02.2018**
(21) Application number: 15880667.9
(22) Date of filing: 31.03.2015
(51) Int. Cl.: H01L 21/52

(54) **TRANSMISSION MEMBER AND PRESSURIZATION UNIT**

(71) Applicant: Shindengen Electric Manufacturing Co., Ltd., Tokyo 100-0004 (JP)
(72) Inventor: MATSUBAYASHI, Ryo, Hanno-shi Saitama 357-8585 (JP)
(74) Representative: Liesegang, Eva
(86) International application number: PCT/JP2015/060296
(87) International publication number: WO 2016/157464

(57) **Abstract**

Provided is transferring members 110, 120 having a plate-like shape used in baking a metal particle paste 4 of an assembled body 20 formed by arranging an electronic part 2 on a substrate 1 with the metal particle paste 4 interposed therebetween by applying pressure to the assembled body 20 and by heating the assembled body 20, the transferring members 110, 120 being configured to sandwich the assembled body in baking the metal particle paste 4, wherein the transferring members 110, 120 are made of a material having thermal conductivity which falls within a range of from 1 to 200W/ (m·k) and Vickers hardness which falls within a range of from 180 to 2300kgf/mm².

With such a configuration, it is possible to provide a transferring member for being used in a method of manufacturing a bonded body which can suppress the lowering of bonding property between a substrate and an electronic part and which can prevent the remarkable lowering of productivity of a bonded body.

## Description

### Technical Field

The present invention relates to a transferring member and a pressure applying unit which are used in baking a metal particle paste of an assembled body formed by arranging an electronic part on a substrate with the metal particle paste interposed therebetween by heating the assembled body while applying pressure to the assembled body using a pair of heating parts.

### Background Art

In a technical field of electronic products, there has been known a bonded body where a substrate and an electronic part are bonded to each other by a baked metal particle paste. As a specific example of such a bonded body, it is possible to name a semiconductor device where a substrate on which a conductor pattern is formed and a semiconductor element are bonded to each other by a baked metal particle paste (see patent literature 1, for example).

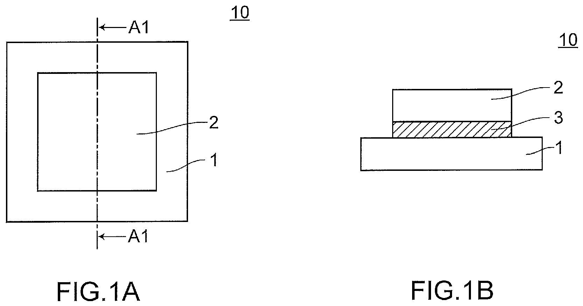

The above-mentioned bonded body is described with reference to drawings. As shown in Fig. 1(a) and Fig. 1(b), a bonded body 10 includes a substrate 1, an electronic part 2 and a baked metal particle paste 3.

The substrate 1 is a printed circuit board on which a conductor pattern is formed, for example.

The electronic part 2 is a semiconductor element, for example.

The baked metal particle paste 3 is a paste obtained by baking a metal particle paste 4 described later.

The substrate 1, the electronic part 2 and the metal particle parte 4 are described in detail in the embodiment 1 described later.

Conventionally, the above-mentioned bonded body 10 is manufactured by the following method, for example.

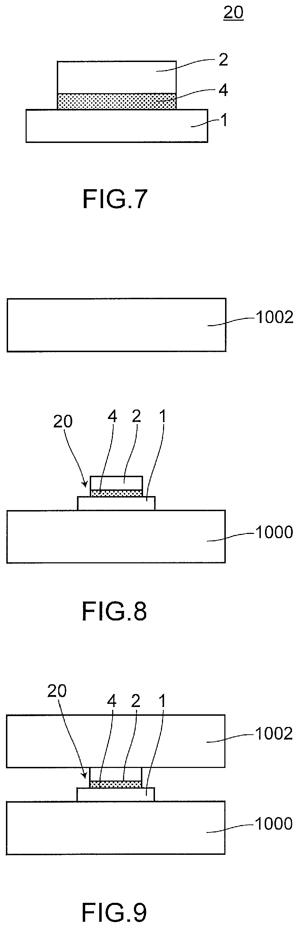

Firstly, an assembled body 20 is prepared as shown in Fig. 7 (first step).

The assembled body 20 is obtained by arranging the electronic part 2 on the substrate 1 with the metal particle paste 4 interposed therebetween.

Next, as shown in Fig. 8, the assembled body 20 is arranged between a pair of heating parts (heating plates) 1000, 1002 (second step). In the method of manufacturing a bonded body described here, the heating part 1000 is arranged on a lower side and hence, the assembled body 20 is arranged on an upper surface of the heating part 1000.

The pair of heating parts 1000, 1002 are arranged at positions where the pair of heating parts 1000, 1002 face each other in an opposed manner, and the heating parts 1000, 1002 are heated by a heating mechanism not shown in the drawing. Further, the pair of heating parts 1000, 1002 are configured such that the heating part 1002 is moved toward the heating part 1000 by a pressure applying mechanism part not shown in the drawing and hence, a pressure can be applied to an object sandwiched between the pair of heating parts 1000, 1002.

Thereafter, as shown in Fig. 9, the heating part 1002 is moved toward the heating part 1000, and the assembled body 20 is heated while being applied with pressure using the pair of heating parts 1000, 1002 thus baking the metal particle paste 4 whereby the bonded body 10 (see Fig. 1(a) and Fig. 1(b)) is manufactured (third step).

According to the conventional method of manufacturing a bonded body, the metal particle paste 4 can be baked by heating the assembled body 20 while applying pressure to the assembled body 20 using the pair of heating parts 1000, 1002 and hence, the substrate 1 and the electronic part 2 can be bonded to each other.

### Citation List

### Patent Literature

Patent Literature 1: JP-A-2012-9703

### Summary of Invention

### Technical Problem

However, in the conventional method of manufacturing a bonded body, before heating the assembled body 20 while applying pressure to the assembled body 20 using the pair of heating parts 1000, 1002, heat is transferred to the metal particle paste 4 from the heating part 1000 thus giving rise to a possibility that a sintering reaction (solidifying reaction) occurs in a portion of the metal particle paste 4. When a sintering reaction occurs in the portion of the metal particle paste 4, there arises a possibility that a baked metal particle paste 3 cannot acquire sufficient density and strength. As a result, there arises a possibility that bonding property between the substrate 1 and the electronic part 2 is lowered.

To suppress the occurrence of such a partial sintering reaction of the metal particle paste, it may be considered reasonable to cool the heating parts at the time of arranging the assembled body and to heat the heating parts after pressure is applied to the assembled body using the pair of heating parts . However, both heating of the heating parts and cooling of the heating parts require a considerable time and hence, when a temperature of heating part is changed each time the assembled body is arranged, there arises a possibility that productivity of the assembled body is remarkably lowered.

The present invention has been made in view of the above-mentioned drawbacks, and it is an object of the present invention to provide a transferring member and a pressure applying unit to be used in a method of manufacturing a bonded body which can suppress the lowering of bonding property between a substrate and an electronic part and which can prevent the remarkable lowering of productivity of a bonded body.

### Solution to Problem

Inventors of the present invention have, in view of the above-mentioned drawbacks, invented a method of manufacturing a bonded body which can suppress the lowering of bonding property between a substrate and an electronic part and which can prevent the remarkable lowering of productivity of a bonded body.

To simply describe the method of manufacturing a bonded body, an assembled body is heated while being applied with pressure by means of a pressure applying unit which includes a pair of transferring members (see respective embodiments described later, particularly the embodiment 1). According to the method of manufacturing a bonded body, with the use of the pressure applying unit, it is possible to suppress unintended heat conduction to a metal particle paste from a heating part and hence, it is possible to acquire the above-mentioned advantageous effects.

The present invention is the invention relating to a transferring member and a pressure applying unit to be used in the above-mentioned method of manufacturing a bonded body, and the present invention is formed of the following constitutional elements.

[1] A transferring member of the present invention is a transferring member having a plate-like shape used in baking a metal particle paste of an assembled body formed by arranging an electronic part on a substrate with the metal particle paste interposed therebetween by applying pressure to the assembled body and by heating the assembled body, the transferring member being configured to sandwich the assembled body in baking the metal particle paste, wherein the transferring member is made of a material having thermal conductivity which falls within a range of from 1 to 200W/ (m·k) and Vickers hardness which falls within a range of from 180 to 2300kgf/mm².
[2] In the transferring member of the present invention, it is preferable that an effective thickness of the transferring member falls within a range of from 1 to 50mm.
[3] In the transferring member of the present invention, it is preferable that the transferring member further include a detachable additional member for increasing the effective thickness of the transferring member.
[4] In the transferring member of the present invention, it is preferable that the transferring member be made of ceramic and have Vickers hardness which falls within a range of from 900 to 2300kgf/mm².
[5] In the transferring member of the present invention, it is preferable that the transferring member be made of tool steel, and have Brinell hardness which falls within a range of from 171 to 1000.
[6] In the transferring member of the present invention, it is preferable that the transferring member be made of stainless steel, and have Brinell hardness which falls within a range of from 171 to 500.
[7] In the transferring member of the present invention, it is preferable that the transferring member be made of carbon steel, and have Brinell hardness which falls within a range of from 171 to 500.
[8] In the transferring member of the present invention, it is preferable that the transferring member be made of a sintered hard alloy containing tungsten, and have Rockwell A-scale hardness which falls within a range of from 80 to 95.
[9] A pressure applying unit of the present invention is a pressure applying unit used in baking a metal particle paste of an assembled body formed by arranging an electronic part on a substrate with the metal particle paste interposed therebetween by heating the assembled body while applying pressure to the assembled body using a pair of heating parts, wherein assuming a time during which predetermined pressure is applied to the pressure applying unit as a pressure applying time, the pressure applying unit includes a pair of transferring members which is constituted of a plate-like first transferring member being in contact with the substrate at least during the pressure applying time and a plate-like second transferring member being in contact with the electronic part at least during the pressure applying time and transfers pressure and heat to the assembled body by sandwiching the assembled body in sintering the metal particle paste, and the first transferring member and the second transferring member are made of a material having thermal conductivity which falls within a range of from 1 to 200W/ (m·k) and Vickers hardness which falls within a range of from 180 to 2300kgf/mm².

### Advantageous Effects of Invention

According to the transferring member of the present invention, by using the transferring member as a constitutional element of the pressure applying unit, unintended heat conduction from the heating part to the metal particle paste can be suppressed and hence, it is possible to suppress the occurrence of a partial sintering reaction (solidifying reaction) of the metal particle paste. As a result, it is possible to suppress the lowering of bonding property between the substrate and the electronic part.

Further, according to the transferring member of the present invention, by using the transferring member as a constitutional element of the pressure applying unit, it is possible to arrange the assembled body without changing a temperature of the heating part thus preventing the remarkable lowering of productivity of a bonded body.

Accordingly, by using the transferring member of the present invention as a constitutional element of the pressure applying unit, the transferring member forms the transferring member which is used in the method of manufacturing a bonded body which can suppress the lowering of bonding property between the substrate and the electronic part and which can prevent the remarkable lowering of productivity of a bonded body.

Further, the transferring member of the present invention is made of a material having thermal conductivity which falls within a range of from 1 to 200W/ (m·K) and Vickers hardness which falls within a range of from 180 to 2300kgf/mm². Accordingly, in baking the metal particle paste, sufficient heat conduction from the heating part to the metal particle paste can be acquired and, at the same time, unintended heat conduction from the heating part to the metal particle paste can be sufficiently suppressed. Further, the deformation of the transferring member caused by a pressure generated during a pressure applying time can be sufficiently suppressed and, at the same time, sufficient toughness can be acquired.

The pressure applying unit of the present invention includes a pair of transferring members and hence, by interposing the pair of transferring members between the assembled body and the pair of heating parts during a pressure applying time, unintended heat conduction from the heating part to the metal particle paste can be suppressed and hence, the occurrence of a partial sintering reaction of the metal particle paste can be suppressed. As a result, the lowering of bonding property between the substrate and the electronic part can be suppressed.

Further, according to the pressure applying unit of the present invention, the pressure applying unit suppresses unintended heat conduction from the heating part to the metal particle paste as described above and hence, the assembled body can be arranged without changing a temperature of the heating part whereby it is possible to prevent the remarkable lowering of productivity of a bonded body.

Accordingly, the pressure applying unit of the present invention forms the pressure applying unit which is used in the method of manufacturing a bonded body which can suppress the lowering of bonding property between the substrate and the electronic part and which can prevent the remarkable lowering of productivity of a bonded body.

Further, the pressure applying unit of the present invention includes the transferring member which is made of a material having thermal conductivity which falls within a range of from 1 to 200W/ (m·K) and Vickers hardness which falls within a range of from 180 to 2300kgf/mm². Accordingly, in baking the metal particle paste, sufficient heat conduction from the heating part to the metal particle paste can be acquired and, at the same time, unintended heat conduction from the heating part to the metal particle paste can be sufficiently suppressed. Further, the deformation of the transferring member caused by a pressure generated during a pressure applying time can be sufficiently suppressed and, at the same time, sufficient toughness can be acquired.

### Brief Description of Drawings

Fig. 1(a) and Fig. 1(b) are conceptual views of a bonded body 10. Fig. 1(a) is a top plan view, and Fig. 1(b) is a cross-sectional view (cross-sectional side view) taken along a line A1-A1 in Fig. 1(a).

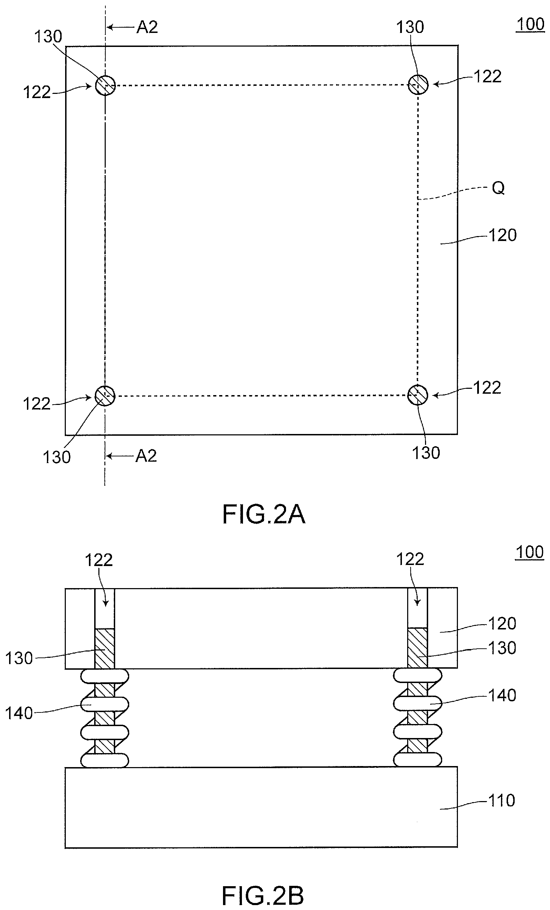

Fig. 2(a) and Fig. 2(b) are views of a pressure applying unit 100 of an embodiment 1. Fig. 2(a) is a top plan view, and Fig. 2(b) is a cross-sectional view (cross-sectional side view) taken along a line A2-A2 in Fig. 2(a). In Fig. 2(b), for facilitating the understanding of drawing, a side surface of a distance adjusting mechanism 140 is shown but not a cross section. The same goes for cross-sectional views described hereinafter.

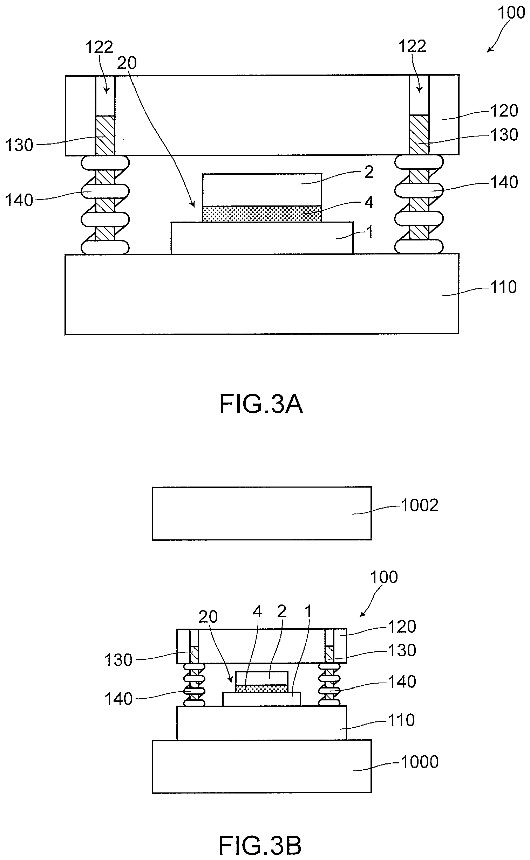

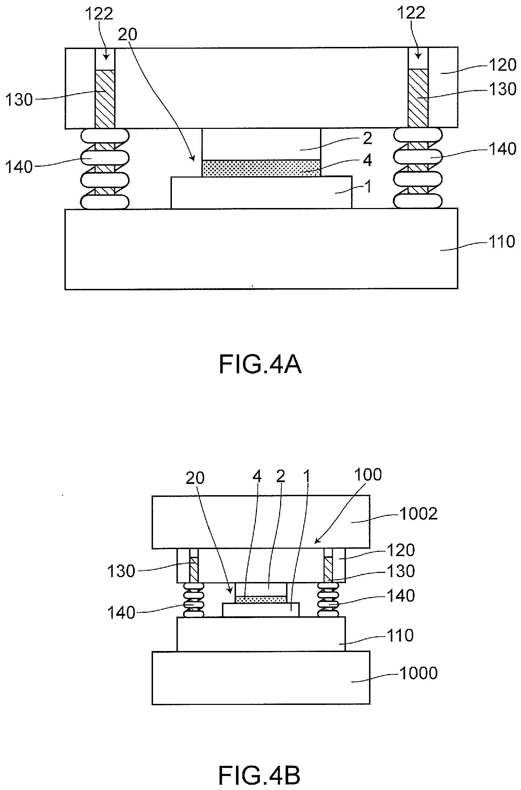

Fig. 3(a) and Fig. 3(b) are views for explaining a second step S20 in a method of manufacturing a bonded body using the pressure applying unit 100 of the embodiment 1. Fig. 3(a) is a cross-sectional side view showing a state of the pressure applying unit 100 and an assembled body 20 when a pressure is not applied, and Fig. 3(b) is a cross-sectional side view showing a state where the pressure applying unit 100 and the assembled body 20 are arranged on a heating part 1000. Fig. 3(b) shows a cross section substantially equal to the cross section shown in Fig. 2(b). The same goes for Fig. 4(b), Fig. 5(a), Fig. 5(b), Fig. 6(a) and Fig. 6(b) described hereinafter.
Fig. 4(a) and Fig. 4(b) are views for explaining a third step S30 in the method of manufacturing a bonded body using the pressure applying unit 100 of the embodiment 1. Fig. 4(a) is a cross-sectional side view showing a state of the pressure applying unit 100 and the assembled body 20 during a pressure applying time, and Fig. 4(b) is a cross-sectional side view showing a state of the pressure applying unit 100, the assembled body 20 and a pair of heating parts 1000, 1002 at the time of heating the pressure applying unit 100 while being applied with pressure using the pair of heating parts 1000, 1002.

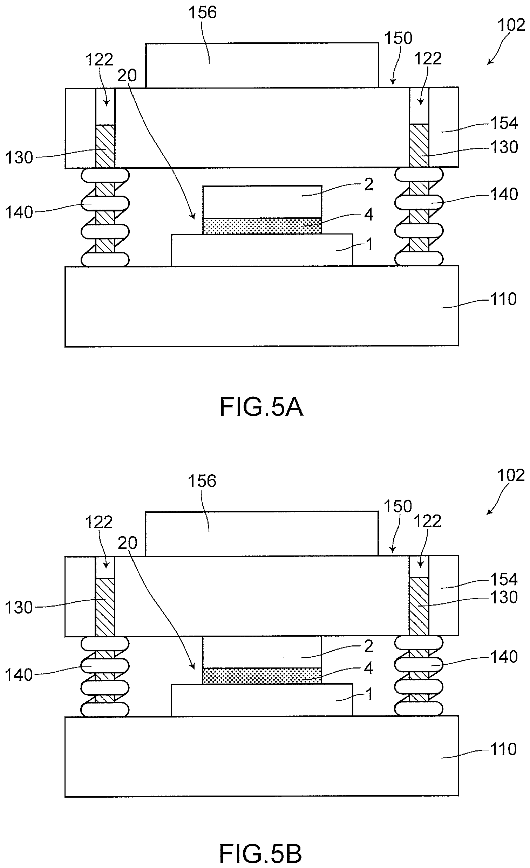

Fig. 5(a) and Fig. 5(b) are views for explaining a pressure applying unit 102 of an embodiment 2. Fig. 5(a) is a cross-sectional side view of the pressure applying unit 102 and an assembled body 20 when a pressure is not applied, and Fig. 5(b) is a cross-sectional side view of the pressure applying unit 102 and the assembled body 20 during a pressure applying time.

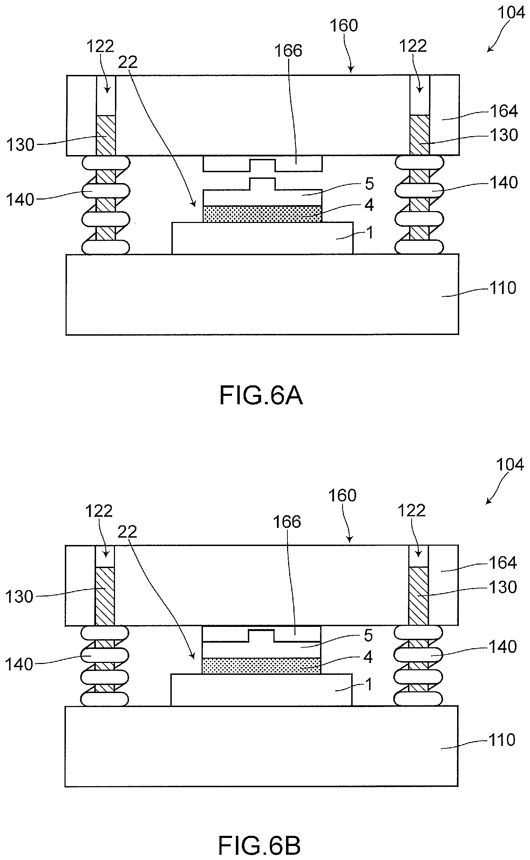

Fig. 6(a) and Fig. 6(b) are views for explaining a pressure applying unit 104 according to a modification. Fig. 6(a) is a cross-sectional side view of the pressure applying unit 104 and an assembled body 22 when a pressure is not applied, and Fig. 6(b) is a cross-sectional side view of the pressure applying unit 104 and the assembled body 22 during a pressure applying time.
Fig. 7 is a view for explaining a first step in a conventional method of manufacturing a bonded body. Fig. 7 is a cross-sectional side view substantially equal to Fig. 1(b) showing a cross section of the bonded body. The same goes for following Fig. 8 and Fig. 9.
Fig. 8 is a view for explaining a second step in the conventional method of manufacturing a bonded body.
Fig. 9 is a view for explaining a third step in the conventional method of manufacturing a bonded body.

### Description of Embodiments

Hereinafter, a transferring member and a pressure applying unit of the present invention are described by reference to embodiments shown in the drawings.

### [Embodiment 1]

In the embodiment 1, the transferring member of the present invention is a constitutional element of the pressure applying unit of the present invention.

A pressure applying unit 100 of an embodiment 1 is a pressure applying unit which is used in baking a metal particle paste 4 of an assembled body 20 formed by arranging an electronic part 2 on a substrate 1 with the metal particle paste 4 interposed therebetween by heating the assembled body 20 while applying pressure to the assembled body 20 using a pair of heating parts 1000, 1002. The assembled body 20 is substantially equal to the assembled body 20 described previously (see Fig. 7) and hence, the repetition of the illustration and the explanation of the assembled body 20 is omitted.

The substrate 1, the electronic part 2 and the metal particle paste 4 are described in detail.

In this specification, "substrate" means a part on which an electronic part is mounted.

The substrate 1 mounts the electronic part 2 thereon. The substrate 1 of the embodiment 1 is, for example, a printed circuit board where a conductor pattern is formed on a body made of a non-conductive material. As a material for forming the substrate 1, a material which has resistance to a sintering temperature of the metal particle paste 4 (for example, 300°C although the sintering temperature depends on a kind of material) can be used (for example, a resin or a ceramic having heat resistance is used for forming the body, and metal is used for forming the conductor pattern).

The substrate to which the present invention is applicable may be a DCB (Direct Copper Bond) substrate or a lead frame. Further, it is sufficient that the substrate to which the present invention is applicable be a substrate on which an electronic part can be mounted. For example, the substrate may be a silicon chip. That is, the present invention is also applicable to the connection between a silicon chip and a conductive connector.

In this specification, "electronic part" means a part which is used in an electric product and is particularly required to be electrically connected to the substrate.

The electronic part 2 is a semiconductor element, for example.

As an electronic part, besides the above-mentioned semiconductor element (for example, a semiconductor chip on which an integrated circuit is mounted), an electric motor, a resistor, a capacitor, a piezoelectric element, a connector, a switch, an antenna, and a conductive connector can be exemplified. The pressure applying unit of the present invention is particularly preferably applicable to a case where a bonded body formed by bonding at least one semiconductor element and a substrate to each other, that is, a semiconductor device is manufactured. Although the number of electronic parts 2 used in the embodiment 1 is one, the present invention is also applicable to the case where two or more electronic parts are used. When two or more electronic parts are used, the electronic parts may be formed of one kind of electronic part, or may be formed of plural kinds of electronic parts.

The metal particle paste 4 is a conductive paste of a low-temperature sintering type which contains nano-sized or submicron-sized metal particles in a solvent, and makes use of a low-temperature sintering phenomenon and high surface activity of the metal particles. The metal particle paste 4 contains metal particles, an organic dispersion material, an organic dispersion material capturing material, and a volatile organic solvent, for example.

As the metal particles, metal nanoparticles (for example, metal particles having an average diameter of approximately 100nm or less), metal submicron particles (for example, metal particles having an average diameter which falls within a range of from approximately 0.1µm to approximately 1µm), or metal particles formed of both the metal nanoparticles and the metal submicron particles can be used. As a material for forming metal particles, silver, gold or copper can be used, for example. The organic dispersion material covers surfaces of metal particles at a room temperature, and has a function of holding metal particles in an independently dispersed state. The organic dispersion material capturing material reacts with the organic dispersion material which covers metal particles at a high temperature and has a function of removing the organic dispersion material from surfaces of the metal particles. The volatile organic solvent has a function of capturing a chemical reaction product formed between the organic dispersion material and the organic dispersion material capturing material and also has a function of releasing the chemical reaction product to the outside of a system in the form of a gas.

Next, the configuration of the pressure applying unit 100 of the embodiment 1 is explained.

As shown in Fig. 2 (a) and Fig. 2(b), the pressure applying unit 100 includes a pair of transferring members 110, 120, guide members 130, and distance adjusting mechanisms 140.

In the explanation made hereinafter, assume a time during which pressure is not applied to the pressure applying unit 100 (see Fig. 3(a)) as a pressure non-applying time, and assume a time during which predetermined pressure is applied to the pressure applying unit 100 (see Fig. 4(a)) as a pressure applying time.

In this specification, "predetermined pressure" means a pressure which is applied to the pressure applying unit 100 in sintering the metal particle paste 4.

The pair of transferring members 110, 120 is constituted of a plate-like first transferring member 110 being in contact with the substrate 1 at least during a pressure applying time and a plate-like second transferring member 120 being in contact with the electronic part at least during a pressure applying time. The pair of transferring members 110, 120 transfers pressure and heat to the assembled body 20 by sandwiching the assembled body 20 in sintering the metal particle paste 4.

The configuration of the first transferring member 110 and the configuration of the second transferring member 120 which form transferring members of the embodiment 1 are explained in detail.

The first transferring member 110 and the second transferring member 120 of the embodiment 1 are plate-like transferring members which are used in baking the metal particle paste 4 of the assembled body 20 formed by arranging the electronic part 2 on the substrate 1 with the metal particle paste 4 interposed therebetween by applying pressure to the assembled body 20 and by heating the assembled body 20, the transferring members being configured to sandwich the assembled body 20 therebetween in baking the metal particle paste 4.

The first transferring member 110 and the second transferring member 120 are made of a material having thermal conductivity which falls within a range of from 1 to 200W/ (m·k) and Vickers hardness which falls within a range of from 180 to 2300kgf/mm².

The reason why the transferring members of the present invention are made of a material having thermal conductivity which falls within a range of from 1 to 200W/(m·k) and Vickers hardness which falls within a range of from 180 to 2300kgf/mm² is as follows. Firstly, when thermal conductivity is less than 1W/ (m·k) , there may be a case where, in baking the metal particle paste, sufficient heat conduction from the heating part to the metal particle paste cannot be acquired. Further, when thermal conductivity is larger than 200W/ (m·k), there may be a case where unintended heat conduction from the heating part to the metal particle paste cannot be sufficiently suppressed. Further, when Vickers hardness is less than 180 kgf/mm², there may be a case where the deformation of the transferring member caused by a pressure generated during a pressure applying time cannot be sufficiently suppressed. Further, when Vickers hardness is larger than 2300 kgf/mm², there may be a case where it becomes difficult for the transferring member to acquire sufficient toughness.

Although there exists no strict correlation between Vickers hardness and toughness (resistance to breakage), the inventors of the present invention have determined the above-mentioned relationship between Vickers hardness and toughness based on studies.

From the above-mentioned viewpoint, it is more preferable that the transferring member be made of a material having thermal conductivity of 10W/ (m·k) or more. Further, it is more preferable that the transferring member be made of a material having thermal conductivity of 180W/(m·k) or less. Further, it is more preferable that the transferring member be made of a material having Vickers hardness of 300 kgf/mm² or more. Further, it is more preferable that the transferring member be made of a material having Vickers hardness of 1700 kgf/mm² or less.

The first transferring member 110 and the second transferring member 120 are respectively formed of a plate-like member having a rectangular shape as viewed in a top plan view. In other words, the first transferring member 110 and the second transferring member 120 are respectively formed of a member having a rectangular parallelepiped shape.

In this specification, "plate-like" means not only a completely plate-like shape (only a rectangular parallelepiped shape and a circular columnar shape) but also an approximately plate-like shape as a whole. That is, the transferring member used in the pressure applying unit of the present invention is not limited to the above-mentioned shape, and it is possible to use a transferring member having a shape corresponding to an assembled body or a method of manufacturing a bonded body (for example, assuming a case where a tray on which the pressure applying unit of the present invention is placed exists and an opening portion or a convex/concave portion for fixing the position of the pressure applying unit is formed on the tray, a transferring member having a projecting portion or a cutout whose shape conforms to a shape of the opening portion or convex/concave portion) . Further, a transferring member used in the pressure applying unit of the present invention may include, besides a plate-like member, other members (for example, an additional part, a spacer, an abutting member having a shape corresponding to a shape of a substrate or a shape of an electronic part and the like) (for example, see an embodiment 2 and a modification described later).

An effective thickness of the first transferring member 110 and the second transferring member 120 falls within a range of from 1 to 50mm.

In this specification, "effective thickness" means a thickness measured in a direction along which a pressure is to be applied during a pressure applying time in a state where a pressure which is equal to a pressure during a pressure applying time is applied to the transferring member at a portion which is brought into contact with the assembled body. The effective thickness takes a value equal to a shortest distance from the heating part to the assembled body during a pressure applying time.

The reason why the effective thickness of the transferring member of the present invention falls within a range of from 1 to 50mm is as follows. Firstly, when the effective thickness of the transferring member is less than 1mm, there may be a case where the transferring member cannot acquire sufficient strength and sufficient durability. On the other hand, when the effective thickness of the transferring member is more than 50mm, it takes time for heat conduction and hence, there may be a case where time for baking the metal particle paste is increased.

From the above-mentioned viewpoint, it is more preferable that the effective thickness of the transferring member be 2mm or above. Further, it is more preferable that the effective thickness of the transferring member be 20mm or below.

It is preferable that the first transferring member 110 and the second transferring member 120 of the embodiment 1 be made of ceramic and have Vickers hardness which falls within a range of from 900 to 2300kgf/mm² respectively. As a specific example of ceramic material, silicon nitride, aluminum nitride, boron nitride, zirconia, silicon carbide, and alumina can be named. To take into account the applicability of the present invention, among the above-mentioned specific examples, a ceramic made of aluminum nitride can be used most preferably.

The reason why Vickers hardness of ceramic is set to a value which falls within a range of from 900 to 2300kgf/mm² is as follows. When Vickers hardness is less than 900kgf/mm², there may be a case where it becomes difficult to form a transferring member due to properties of the material. On the other hand, when Vickers hardness is larger than 2300kgf/mm², there may be a case where it becomes difficult for the transferring member to acquire sufficient toughness.

It is also preferable that the first transferring member 110 and the second transferring member 120 of the embodiment 1 be respectively made of tool steel and have Brinell hardness which falls within a range of from 171 to 1000 respectively. As specific examples of tool steel, various kinds of die steels and various kinds of high-speed tool steels can be named.

The reason why Brinell hardness of tool steel is set to a value which falls within a range of from 171 to 1000 is as follows. When Brinell hardness is less than 171, there may be a case where the deformation of the transferring member caused by a pressure generated during a pressure applying time cannot be sufficiently suppressed. Further, it is difficult to realize tool steel having Brinell hardness of more than 1000 due to properties of the material.

It is also preferable that the first transferring member 110 and the second transferring member 120 of the embodiment 1 be respectively made of stainless steel, and have Brinell hardness which falls within a range of from 171 to 500 respectively. As stainless steel, provided that the above-mentioned requirements in thermal conductivity and Vickers hardness are satisfied, various kinds of stainless steels such as martensitic stainless steel, ferritic stainless steel and austenitic stainless steel can be used.

The reason why Brinell hardness of stainless steel is set to a value which falls within a range of from 171 to 500 is as follows. When Brinell hardness is less than 171, there may be a case where the deformation of the transferring member caused by a pressure generated during a pressure applying time cannot be sufficiently suppressed. Further, it is difficult to realize stainless steel having Brinell hardness of more than 500 due to properties of the material.

It is also preferable that the first transferring member 110 and the second transferring member 120 of the embodiment 1 be respectively made of carbon steel, and have Brinell hardness which falls within a range of from 171 to 500 respectively. As carbon steel, provided that the above-mentioned requirements in thermal conductivity and Vickers hardness are satisfied, carbon steel having various carbon contents can be used.

The reason why Brinell hardness of carbon steel is set to a value which falls within a range of from 171 to 500 is as follows. When Brinell hardness is less than 171, there may be a case where the deformation of the transferring member caused by a pressure generated during a pressure applying time cannot be sufficiently suppressed. Further, it is difficult to realize carbon steel having Brinell hardness of more than 500 due to properties of the material.

It is also preferable that the first transferring member 110 and the second transferring member 120 of the embodiment 1 be respectively made of a sintered hard alloy containing tungsten, and have Rockwell A-scale hardness which falls within a range of from 80 to 95 respectively. The sintered hard alloy may contain various kinds of binders (for example, cobalt) and other metal carbides (for example, titanium carbide, tantalum carbide and the like) besides tungsten (particularly, tungsten carbide).

The reason why Rockwell hardness of the sintered hard alloy is set to a value which falls within a range of from 80 to 95 is as follows. When Rockwell hardness is less than 80, there may be a case where it becomes difficult to form a transferring member due to properties of the material. Further, when Rockwell hardness is larger than 95, there may be a case where it becomes difficult for the transferring member to acquire sufficient toughness.

Guide member receiving holes 122 which correspond to the guide members 130 respectively are formed in the second transferring member 120. In the embodiment 1, four guide member receiving holes 122 in total are formed on four corners of the second transferring member 120 such that one guide member receiving hole 122 is formed in each corner of the second transferring member 120. The second transferring member 120 can move along the guide members 130 respectively inserted into the guide member receiving holes 122.

In the technical feature of "the second transferring member can move along the guide members respectively inserted into the guide member receiving holes", "move" means the relative movement of the second transferring member relative to the first transferring member. Depending on the manner of applying pressure to the pressure applying unit, there may be a case where the second transferring member is held stationary and the first transferring member and the guide members are movable as viewed from the outside (for example, a case where a pressure is applied to the pressure applying unit and the assembled body by moving the heating part disposed on a lower side in a direction toward the heating part disposed on an upper side). Also in this case, the second transferring member is moved relative to the first transferring member and hence, such movement is included in the above-mentioned movement.

The guide member receiving hole 122 is a through hole having a circular shape as viewed in a top plan view in conformity with a shape of the guide member 130 (a circular columnar shape as described later). The shape of the guide member receiving hole of the present invention is not limited to a circular shape as viewed in a top plan view, and it is sufficient for the guide member receiving hole to have a shape in conformity with a shape of the guide member. Further, the guide member receiving hole may be a hole (a bottomed hole) other than the through hole.

The guide members 130 connect the pair of transferring members 110, 120 to each other and, at the same time, allow the movement of at least one transferring member out of the first transferring member 110 and the second transferring member 120 while keeping parallelism of one transferring member with the other transferring member. In the embodiment 1, the guide members 130 allow the movement of the second transferring member 120 while keeping parallelism of the second transferring member 120 with the first transferring member 110 (the expression "allow the movement of" being also made by an expression "guide"). From a viewpoint of ensuring stability of the movement of the transferring member, it is preferable for the pressure applying unit of the present invention to include two or more guide members, and more preferably, to include four or more guide members.

The pressure applying unit 100 includes two or more guide members, specifically, four guide members. When the guide members 130 are viewed in a direction perpendicular to a surface of the first transferring member 110 on which the substrate 1 is arranged, the guide members 130 are arranged at least at apexes of a predetermined quadrangular shape surrounding a place where the assembled body 20 is to be arranged (see a broken line indicated by symbol Q in Fig. 2(a)). In the embodiment 1, four guide members 130 in total are arranged on four corners of the first transferring member 110 such that one guide member 130 is arranged in each corner of the first transferring member 110.

One end portions of the guide members 130 are respectively fixed to the first transferring member 110. The other end portions of the guide members 130 on a side opposite to one end portions are arranged in the inside of the guide member receiving holes 122 respectively during a pressure applying time (see Fig. 4(a) and Fig. 4(b)).

The guide members 130 are made of metal such as stainless steel, for example.

In the embodiment 1, all four guide members 130 have a circular columnar shape. The number of guide members used in the present invention is not limited to four, and may be 1 to 3 or 5 or more provided that the guide members can achieve their purpose. Further, the shape of the guide members of the present invention is not limited to a circular columnar shape, and the shape of the guide members may be other shapes (to be more specific, a prismatic shape, an elliptical shape, a flat plate shape, a corrugated shape, an L shape or a T shape) provided that the guide members can achieve their purpose.

The distance adjusting mechanism 140 is a mechanism for adjusting a distance between the first transferring member 110 and the second transferring member 120. In a state where the assembled body 20 is arranged between the pair of transferring members 110, 120, the distance adjusting mechanism 140 makes the first transferring member 110 or the second transferring member 120 separated from the assembled body 20 during a pressure non-applying time, and brings both the first transferring member 110 and the second transferring member 120 into contact with the assembled body 20 during a pressure applying time. The distance adjusting mechanism 140 includes a resilient member which extends during a pressure non-applying time, and shrinks during a pressure applying time. The resilient member is formed of a coil spring, and is arranged using the guide member 130 as a shaft.

The distance adjusting mechanism of the present invention is not limited to the resilient member, and the distance adjusting mechanism may be a member which is configured to shrink when a pressurizing state of the distance adjusting mechanism is shifted to a pressure applying time from a pressure non-applying time but does not extend when the pressurizing state is shifted to the pressure non-applying time from the pressure applying time (for example, a multi-stage pipe having the telescopic structure).

Further, the resilient member of the present invention is not limited to a coil spring, a member which can withstand a temperature at the time of sintering a metal particle paste can be used. As a specific example of the resilient member other than the coil spring, a leaf spring and heat resistance rubber can be named.

The distance adjusting mechanism of the present invention may include a constitutional element other than the resilient member (for example, a member which supports the resilient member or a member which reinforces the resilient member).

In this specification, the expression "arranged using the guide member 130 as a shaft" is used with respect to the coil spring. This expression means that the coil spring is arranged in a state where the guide member is disposed in a hollow portion of the coil spring.

The resilient member of the present invention may be arranged at a position different from a position where the guide member is arranged. Further, the resilient member of the present invention may be arranged using a constitutional element other than the guide member as a shaft. Only the resilient member may be arranged (without using a shaft).

Further, the pressure applying unit of the present invention may not include the distance adjusting mechanism.

Next, a method of manufacturing a bonded body using the first transferring member 110 and the second transferring member 120 which form the transferring members of the embodiment 1 and the pressure applying unit 100 of the embodiment 1 is simply explained.

The method of manufacturing the above-mentioned bonded body includes following steps, that is, a first step S10, a second step S20, and a third step S30 in this order.

The first step S10 is a step where the assembled body 20 is prepared. This step is substantially equal to the step shown in Fig. 7 and hence, the illustration of the step is omitted.

The first step S10 can be performed such that, for example, after preparing the substrate 1, the electronic part 2 and the metal particle paste 4, the metal particle paste 4 is applied by coating to a predetermined place of the substrate 1 (for example, contact points with the electronic part2), and the electronic part 2 is arranged on the place.

As shown in Fig. 3(a) and Fig. 3(b), the second step S20 is a step where the assembled body 20 is sandwiched between the pair of transferring members 110, 120 of the pressure applying unit 100 and, thereafter, the assembled body 20 is arranged between the pair of heating parts 1000, 1002 together with the pressure applying unit 100.

In the second step S20 of the embodiment 1, although the assembled body 20 and the pressure applying unit 100 are directly arranged on the heating part 1000, the assembled body 20 and the pressure applying unit 100 may be arranged between the heating parts 1000, 1002 (that is, in a spaced-apart manner from the heating part 1000).

As shown in Fig. 4(b), the third step S30 is a step where the heating part 1002 disposed on an upper side is moved toward the heating part 1000, and the metal particle paste 4 is baked by heating the assembled body 20 together with the pressure applying unit 100 while applying pressure to the assembled body 20 using a pair of heating parts 1000, 1002 thus manufacturing the bonded body 10.

In the third step S30 of the embodiment 1, the heating part 1002 is moved. However, the heating part 1000 may be moved or both heating parts 1000, 1002 may be moved.

Hereinafter, advantageous effects of the first transferring member 110 and the second transferring member 120 which form the transferring members of the embodiment 1 and advantageous effects of the pressure applying unit 100 of the embodiment 1 are explained.

According to the first transferring member 110 and the second transferring member 120 of the embodiment 1, by using the first transferring member 110 and the second transferring member 120 as constitutional elements of the pressure applying unit 100, unintended heat conduction to the metal particle paste 4 from the heating parts 1000, 1002 can be suppressed and hence, it is possible to suppress the occurrence of a partial sintering reaction of the metal particle paste 4. As a result, it is possible to suppress the lowering of bonding property between the substrate and the electronic part.

Further, according to the first transferring member 110 and the second transferring member 120 of the embodiment 1, by using the first transferring member 110 and the second transferring member 120 as constitutional elements of the pressure applying unit 100, it is possible to arrange the assembled body 20 without changing a temperature of the heating parts 1000, 1002 thus preventing the remarkable lowering of productivity of a bonded body.

Accordingly, by using the first transferring member 110 and the second transferring member 120 of the embodiment 1 as constitutional elements of the pressure applying unit 100, the transferring members 110, 120 form the transferring members which are used in the method of manufacturing a bonded body which can suppress the lowering of bonding property between the substrate and the electronic part and which can prevent the remarkable lowering of productivity of a bonded body.

Further, the first transferring member 110 and the second transferring member 120 of the embodiment 1 are made of a material having thermal conductivity which falls within a range of from 1 to 200W/ (m·K) and Vickers hardness which falls within a range of from 180 to 2300kgf/mm². Accordingly, in baking the metal particle paste, sufficient heat conduction from the heating part to the metal particle paste can be acquired and, at the same time, unintended heat conduction from the heating part to the metal particle paste can be sufficiently suppressed. Further, the deformation of the transferring member caused by a pressure generated during a pressure applying time can be sufficiently suppressed and, at the same time, sufficient toughness can be acquired.

According to the first transferring member 110 and the second transferring member 120 of the embodiment 1, an effective thickness of the first transferring member 110 and the second transferring member 120 falls within a range of from 1 to 50mm and hence, sufficient strength and sufficient durability can be acquired, and the increase of time required for baking the metal particle paste can be suppressed.

According to the first transferring member 110 and the second transferring member 120 of the embodiment 1, when the first transferring member 110 and the second transferring member 120 are made of ceramic, ceramic is a material excellent particularly in hardness and hence, it is possible to reduce unevenness of pressure applied to the bonded body by suppressing the deformation of the transferring member during a pressure applying time.

According to the first transferring member 110 and the second transferring member 120 of the embodiment 1, when the first transferring member 110 and the second transferring member 120 are made of tool steel, tool steel is a material excellent in hardness and toughness and hence, it is possible to reduce unevenness of pressure applied to the bonded body by suppressing the deformation of the transferring member during a pressure applying time, and it is possible to increase durability.

According to the first transferring member 110 and the second transferring member 120 of the embodiment 1, when the first transferring member 110 and the second transferring member 120 are made of stainless steel, stainless steel is a material excellent in availability and weatherability and hence, the first transferring member 110 and the second transferring member 120 can be easily obtained and it is possible to suppress the deterioration caused by oxidation or the like.

According to the first transferring member 110 and the second transferring member 120 of the embodiment 1, when the first transferring member 110 and the second transferring member 120 are made of carbon steel, carbon steel is a material excellent particularly in availability and hence, the first transferring member 110 and the second transferring member 120 can be more easily obtained.

According to the first transferring member 110 and the second transferring member 120 of the embodiment 1, when the first transferring member 110 and the second transferring member 120 are made of a sintered hard alloy containing tungsten, the sintered hard alloy is a material excellent particularly in hardness and hence, it is possible to reduce unevenness of pressure applied to the bonded body by suppressing the deformation of the transferring member during a pressure applying time.

The pressure applying unit 100 of the embodiment 1 includes the pair of transferring members 110, 120 and hence, by interposing the pair of transferring members 110, 120 between the assembled body and the pair of heating parts during a pressure applying time, unintended heat conduction from the heating part to the metal particle paste can be suppressed and hence, the occurrence of a partial sintering reaction of the metal particle paste can be suppressed. As a result, the lowering of bonding property between the substrate and the electronic part can be suppressed.

Further, according to the pressure applying unit 100 of the embodiment 1, the pressure applying unit 100 suppresses unintended heat conduction from the heating parts 1000, 1002 to the metal particle paste 4 and hence, the assembled body can be arranged without changing a temperature of the heating part whereby it is possible to prevent the remarkable lowering of productivity of a bonded body.

Accordingly, the pressure applying unit 100 of the embodiment 1 forms the pressure applying unit which is used in the method of manufacturing a bonded body which can suppress the lowering of bonding property between the substrate and the electronic part and which can prevent the remarkable lowering of productivity of a bonded body.

Further, the pressure applying unit of the embodiment 1 includes the pair of transferring members 110, 120 which is made of a material having thermal conductivity which falls within a range of from 1 to 200W/ (m·K) and Vickers hardness which falls within a range of from 180 to 2300kgf/mm². Accordingly, in baking the metal particle paste, sufficient heat conduction from the heating part to the metal particle paste can be acquired and, at the same time, unintended heat conduction from the heating part to the metal particle paste can be sufficiently suppressed. Further, the deformation of the transferring member caused by a pressure generated during a pressure applying time can be sufficiently suppressed and, at the same time, sufficient toughness can be acquired.

### [Embodiment 2]

A second transferring member 150 which constitutes a transferring member of an embodiment 2 basically has substantially the same configuration as the second transferring member 120 of the embodiment 1. However, the second transferring member 150 is different from the second transferring member 120 of the embodiment 1 with respect to a point that the second transferring member 150 includes a detachable additional member for increasing an effective thickness of the transferring member.

As shown in Fig. 5(a) and Fig. (b), the second transferring member 150 of the embodiment 2 has an additional member 156 besides a member 154 having a rectangular parallelepiped shape. In the embodiment 2, the second transferring member 150 has the additional member 156 on a side thereof opposite to a first transferring member 110 side (a heating part 1002 side).

In Fig. 5, symbol 102 indicates a pressure applying unit of the embodiment 2.

Although not shown in the drawing, for fixing the additional member 156 to the member 154 having a rectangular parallelepiped shape, for example, various methods can be used including fixing using bolts and fixing by fitting engagement between a projecting portion and a recessed portion. Further, provided that pressure and heat can be stably applied to an assembled body during a pressure applying time, it is not always necessary to fix the additional member 156 to the member 154 having a rectangular parallelepiped shape.

The member 154 having a rectangular parallelepiped shape is a member substantially equal to the member having a rectangular parallelepiped shape which forms the second transferring member 120 of the embodiment 1.

The additional member 156 is a detachable additional member for increasing an effective thickness of the second transferring member 150. The additional member 156 has a rectangular parallelepiped shape and is one size smaller than the member 154 having a rectangular parallelepiped shape.

It is preferable that the additional member 156 be made of a material having thermal conductivity which falls within a range of from 1 to 200W/ (m·k) and Vickers hardness which falls within a range of from 180 to 2300kgf/mm². Further, it is more preferable that the additional member 156 be made of ceramic, tool steel, stainless steel, carbon steel, or a sintered hard alloy containing tungsten which satisfies the above-mentioned requirements in thermal conductivity and Vickers hardness.

In the embodiment 2, although the second transferring member 150 includes the additional member 156, the first transferring member may include an additional member.

Although one additional member 156 is used in the embodiment 2, a plurality of additional members may be used. When a plurality of additional members are used, another additional member may be made to overlap with one additional member.

Further, in the embodiment 2, although the additional member 156 has a rectangular parallelepiped shape and is one size smaller than the member 154 having a rectangular parallelepiped shape. However, the additional member of the present invention may have a shape (a circular columnar shape, a prismatic shape or the like) other than the above-mentioned shape. Further, the additional member may be formed of a solid body or may be formed of a hollow body having a space in the inside thereof.

As described above, the second transferring member 150 of the embodiment 2 differs from the second transferring member 120 of the embodiment 1 with respect to a point that the second transferring member 150 includes the additional member. However, using the second transferring member 150 as a constitutional element of the pressure applying unit, unintended heat conduction from the heating part to the metal particle paste can be suppressed and hence, it is possible to suppress the occurrence of a partial sintering reaction of the metal particle paste. Further, it is possible to arrange the assembled body without changing a temperature of the heating part and hence, by using the second transferring member 150 as a constitutional element of the pressure applying unit in the substantially same manner as the second transferring member 120 of the embodiment 1, the transferring member 150 forms the transferring member which is used in the method of manufacturing a bonded body which can suppress the lowering of bonding property between the substrate and the electronic part and which can prevent the remarkable lowering of productivity of a bonded body.

Further, according to the second transferring member 150 of the embodiment 2, the second transferring member 150 includes the detachable additional member 156 for increasing an effective thickness of the second transferring member 150 and hence, it is possible to change a state of heat conduction to the assembled body using the additional member.

The second transferring member 150 of the embodiment 2 basically has substantially the same configuration as the second transferring member 120 of the embodiment 1 except for the point that the second transferring member 150 includes the additional member. Accordingly, the second transferring member 150 of the embodiment 2 can acquire advantageous effects which correspond to the advantageous effects out of the advantageous effects which the second transferring member 120 of the embodiment 1 can acquire.

Although the present invention has been explained heretofore by reference to the above-mentioned respective embodiments, the present invention is not limited to the above-mentioned respective embodiments. Various modifications are conceivable without departing from the gist of the present invention. For example, the following modifications are also conceivable.

(1) The number, materials, shapes, positions, sizes and the like of the constitutional elements described in the above-mentioned respective embodiments are merely examples, and can be changed within a range where the advantageous effects of the present invention are not impaired.
(2) In the above-mentioned embodiment 1, the present invention has been explained using the first transferring member 110 and the second transferring member 120 which are respectively formed of a member having a rectangular parallelepiped shape. However, the present invention is not limited to such a configuration. As shown in Fig. 6 (a) and Fig. 6(b), a pressure applying unit 104 according to a modification is a pressure applying unit which is used in baking a metal particle paste 4 of an assembled body 22 formed by arranging an electronic part 5 on a substrate 1 with the metal particle paste 4 interposed therebetween by heating the assembled body 22 while applying pressure to the assembled body 22 using a pair of heating parts. The electronic part 5 is basically substantially equal to the electronic part 2 of the embodiment 1. However, the electronic part 5 has a projecting portion on a side thereof opposite to a substrate 1 side. A second transferring member 160 of the pressure applying unit 104 basically has substantially the same configuration as the second transferring member 120 of the embodiment 1. However, the second transferring member 160 includes a member 164 having a rectangular parallelepiped shape and an abutting member 166. The member 164 having a rectangular parallelepiped shape is a member substantially equal to the member having a rectangular parallelepiped shape which forms the second transferring member 120 of the embodiment 1, and the abutting member 166 is a member having a recessed portion on a first transferring member 110 side thereof. The recessed portion of the abutting member 166 corresponds to the projecting portion of the electronic part 5. For example, as shown in the modification, the transferring member of the present invention may have a member other than the plate-like member or the additional member.

### Reference Signs List

1: substrate, 2, 5: electronic part, 3: baked metal particle paste, 4: metal particle paste, 10: bonded body, 20, 22: assembled body, 100, 102, 104: pressure applying unit, 110: first transferring member, 120, 150, 160: second transferring member, 122: guide member receiving hole, 130: guide member, 140: distance adjusting mechanism, 154, 164: member having rectangular parallelepiped shape, 156: additional member, 166: abutting member, 1000, 1002: heating part, Q: predetermined quadrangular shape

## Claims

1. A transferring member having a plate-like shape used in baking a metal particle paste of an assembled body formed by arranging an electronic part on a substrate with the metal particle paste interposed therebetween by applying pressure to the assembled body and by heating the assembled body, the transferring member being configured to sandwich the assembled body in baking the metal particle paste, wherein
the transferring member is made of a material having thermal conductivity which falls within a range of from 1 to 200W/ (m·k) and Vickers hardness which falls within a range of from 180 to 2300kgf/mm².

2. The transferring member according to claim 1, wherein an effective thickness of the transferring member falls within a range of from 1 to 50mm.

3. The transferring member according to claim 1 or 2, wherein the transferring member further includes a detachable additional member for increasing the effective thickness of the transferring member.

4. The transferring member according to any one of claims 1 to 3, wherein the transferring member is made of ceramic and has Vickers hardness which falls within a range of from 900 to 2300kgf/mm².

5. The transferring member according to any one of claims 1 to 3, wherein the transferring member is made of tool steel, and has Brinell hardness which falls within a range of from 171 to 1000.

6. The transferring member according to any one of claims 1 to 3, wherein the transferring member is made of stainless steel, and has Brinell hardness which falls within a range of from 171 to 500.

7. The transferring member according to any one of claims 1 to 3, wherein the transferring member is made of carbon steel, and has Brinell hardness which falls within a range of from 171 to 500.

8. The transferring member according to any one of claims 1 to 3, wherein the transferring member is made of a sintered hard alloy containing tungsten, and has Rockwell A-scale hardness which falls within a range of from 80 to 95.

9. A pressure applying unit used in baking a metal particle paste of an assembled body formed by arranging an electronic part on a substrate with the metal particle paste interposed therebetween by heating the assembled body while applying pressure to the assembled body using a pair of heating parts, wherein
assuming a time during which predetermined pressure is applied to the pressure applying unit as a pressure applying time,
the pressure applying unit includes a pair of transferring members which is constituted of a plate-like first transferring member being in contact with the substrate at least during the pressure applying time and a plate-like second transferring member being in contact with the electronic part at least during the pressure applying time and transfers pressure and heat to the assembled body by sandwiching the assembled body in sintering the metal particle paste, and
the first transferring member and the second transferring member are made of a material having thermal conductivity which falls within a range of from 1 to 200W/ (m·k) and Vickers hardness which falls within a range of from 180 to 2300kgf/mm².
